# EUROPÄISCHE PATENTSCHRIFT

(11) **EP 0 567 204 B1**
(45) Veröffentlichungstag und Bekanntmachung des Hinweises auf die Patenterteilung: **16.12.1998**
(21) Anmeldenummer: 93250095.2
(22) Anmeldetag: 26.03.1993
(51) Int. Cl.: H04J 3/14, H04M 3/24

(54) **Verfahren und Schaltungsanordnung zur Überwachung digitaler, periodischer Signale**
Method and circuit for monitoring digital periodical signals
Méthode et dispositif de surveillance des signaux numériques périodiques

(30) Priorität: 22.04.1992 DE 4213259
(43) Veröffentlichungstag der Anmeldung: 27.10.1993
(73) Patentinhaber: TEKTRONIX, INC., Wilsonville, Oregon 97070-1000 (US)
(72) Erfinder: Kolbinger, Josef, W-8305 Ergoldsbach (DE)
(74) Vertreter: Hofstetter, Alfons J., Dr.rer.nat.

(56) Entgegenhaltungen:
- EP-A- 0 419 960
- US-A- 4 611 320

## Beschreibung

Die Erfindung betrifft ein Verfahren zur Überwachung von digitalen periodischen Signalen und eine Schaltungsanordnung zur Durchführung einer solchen Überwachung.

Die Vorteile der Digitaltechnik gegenüber der Analogtechnik haben dazu geführt, daß man sich bei der Nachrichtenübermittlung heutzutage vorwiegend digitaler Signale bedient. Um die dabei verwendeten Übertragungsmedien wirtschaftlich zu nutzen, bedient man sich dabei unter anderem der Zeitmultiplex-Technik, d.h. verschiedene Nachrichten werden zeitlich abwechselnd über ein und dieselbe Leitung übertragen. Ein bekanntes System ist dabei das sogenannte PCM 30 Grundsystem. Bei diesem Zeitmultiplexsystem werden abwechselnd 30 Nutzkanäle und 2 Signalisierungskanäle übertragen. Aus der Datenrate von 64 Kilobit/s für einen einzelnen Kanal ergibt sich eine Gesamtdatenrate von 2,048 Megabit/s für das PCM-Signal.Die Überwachung eines Signals mit derartig hoher Datenrate ist nun außerordentlich schwierig. Sie wird bislang so durchgeführt, daß in einem Beobachtungszeitraum das gesamte Signal aufgezeichnet, d.h. gespeichert wird, und danach das aufgezeichnete Signal auf Fehler untersucht wird. Die Fehlersuche besteht darin, bestimmte Kanäle, in denen ein konstanter Wert, also 0 oder 1 erwartet wird, zu überprüfen, ob dieser Wert tatsächlich über den gesamten Zeitraum beibehalten wird oder ob Abweichungen, also Fehler auftreten.

Es ist ferner ein programmierbarer Testanalysator für eine Nachrichtenübertragungsstrecke bekannt (US-Patentschrift US-A 4 611 320), bei dem Testsignale unter Benutzung mehrerer Speicherplätze eines Ausgangsbuffers gebildet und nach Aussendung und Wiederempfang in aufeinanderfolgenden Speicherplätzen eines anderen Buffers gespeichert werden. Ist schließlich das ganze empfangene Testsignal abgespeichert, dann kann es off-line zum Zwecke einer Analyse untersucht werden, beispielsweise mit dem ausgesendeten Testsignal verglichen werden.

Der Erfindung liegt die Aufgabe zugrunde, die Überwachung und Fehlersuche bei digitalen periodischen Signalen zu verbessern.

Dies geschieht erfindungsgemäß mit einem Verfahren nach Anspruch 1. Mit dem erfindungsgemäßen Verfahren wird der Speicheraufwand zur Überwachung auf einen Bruchteil des für eine herkömmliche Überwachung erforderlichen Wertes reduziert. Bei einem PCM 30 System benötigt man beispielsweise für die Speicherung einer Sekunde des Signals 2,048 Megabit (entsprechend der Datenrate). Mit dem erfindungsgemäßen Verfahren zur Überwachung benötigt man aber nur den Speicherbedarf für einen Rahmen des PCM 30 Signals und 1 bit pro Kanal also 256 + 32 = 288 Bit. Dies entspricht etwa einem 7000-tel des ursprünglichen Wertes.

Die Auswertung der registrierten Abweichungen ergibt eine umfassende Information über das überwachte Signal. So zeigen registrierte Änderungen bei Kanälen, bei denen ein konstanter Wert vorliegen sollte an, daß ein Übertragungsfehler vorliegt. Gleichzeitig geben die Abweichungen in einem fehlerfreien System Auskunft darüber, welche Kanäle belegt sind, d.h. Signale führen. Überdies zeigt das Fehlen einer Abweichung in einem Kanal, der ein Signal führen sollte, an, daß dieser Kanal gestört ist.

Bei einer Ausgestaltung der Erfindung gemäß Anspruch 2 sind Fehler und die davon betroffenen Kanäle eines Zeitmultiplexsignales besonders einfach erkennbar.

Eine Ausgestaltung der Erfindung gemäß Anspruch 3 bewirkt einen besonders geringen Realisierungsaufwand.

Besonders vorteilhaft ist es, wenn die Erfindung mittels einer Schaltungsanordnung nach Anspruch 4 realisiert wird.

Diese Schaltungsanordnung ermöglicht den Einsatz der Erfindung auch bei sehr hohen Datenraten des zu überwachenden digitalen Signals.

Die Erfindung wird anhand einer Figur näher erläutert, welche eine beispielhafte Schaltungsanordnung zur Durchführung des erfindungsgemäßen Verfahrens darstellt.

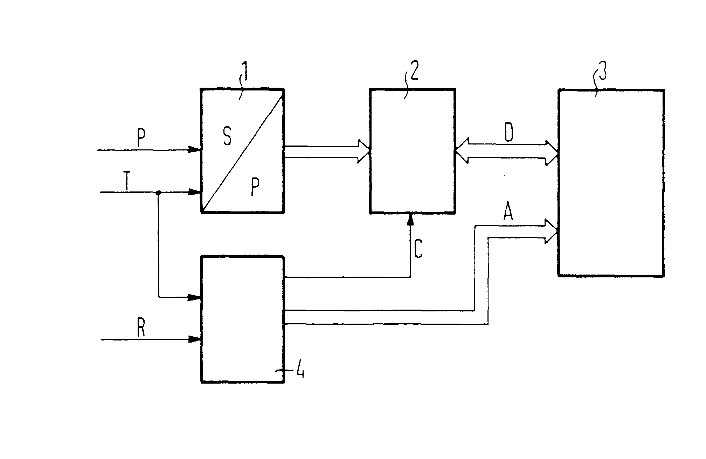

Die Schaltungsanordnung nach Figur 1 umfaßt eine erste Schaltung 1 zur Seriell/Parallel-Umsetzung des digitalen, periodischen Eingangssignales, eine Vergleichslogik 2, eine Speichereinrichtung 3 und eine Steuereinrichtung 4. Am seriellen Eingang der ersten Schaltung 1 zur Seriell/Parallel-Umsetzung liegt das PCM 30 Eingangssignal P an. Zusätzlich wird die erste Schaltung 1 mit einem Taktsignal T versorgt. Am Ausgang der ersten Schaltung 1, der mit einem Eingang der Vergleichslogik 2 verbunden ist, liegt nun ein byteweise paralleles Signal vor. Von der Vergleichslogik 2 wird nun das Bitmuster des ersten Rahmens (der ersten Signalperiode des PCM 30-Eingangssignales d.h. also die ersten 32 Byte eines Beobachtungszeitraumes) über einen bidirektionalen Datenbus D an die Speichereinrichtung 3 weitergegeben und dort gespeichert. Die Bitmuster der folgenden Rahmen (Signalperioden) des PCM 30-Eingangssignales P werden dann byteweise mit dem gespeicherten Bitmuster des ersten Rahmens verglichen. Der Vergleich erfolgt durch eine Exklusiv-Oder-Verknüpfung der beiden Bytes. Das Ergebnis wird in die Speichereinrichtung 3 übertragen und dort in einem Abweichungsspeicherbereich (32 bit entsprechend den 32 Kanälen) gespeichert. Die Steuerung der Vergleichs- und Speichervorgänge erfolgt mittels Steuerlogik 4, welche über Kontrolleitungen A, C mit der Speichereinrichtung 3 und der Vergleichslogik 2 verbunden ist. Die Synchronisation der Steuerlogik 4 mit dem PCM 30-Eingangssignal erfolgt über ein Eingangstaktsignal und ein aus dem PCM 30-Eingangssignal P abgeleitetes Rahmensynchronsignal R.

Im folgenden wird nun der Vergleich eines Rahmens (Signalperiode des PCM 30-Eingangssignales) mit dem ersten Rahmen (Signalperiode eines Beobachtungszeitraumes) beschrieben: Aus dem Zustand des Rahmensynchronsignales R erkennt die Steuerlogik 4 daß ein neuer Rahmen beginnt. Mittels Kontrolleitungen A wird aus der Speichereinrichtung 3 das erste Byte des ersten Rahmens (Signalperiode) über den bidirektionalen Datenbus D in die Vergleichslogik 2 eingelesen. Gleichzeitig erhält die Vergleichslogik 2 aus der ersten Schaltung 1 das erste Byte des aktuellen Rahmens. Die beiden Bitmuster werden über eine Exklusiv-Oder-Verknüpfung miteinander verglichen, das Ergebnis wird über eine Oder-Verknüpfung mit dem ersten Byte des Abweichungsspeicherbereichs verknüpft und das Ergebnis dieser Verknüpfung (0 oder 1) im Abweichungsspeicherbereich an der dem ersten Byte zugeordneten Stelle gespeichert. Derselbe Vorgang wird für alle 32 Byte des aktuellen Rahmens wiederholt. Durch die beschriebene Oder-Verknüpfung wird gewährleistet, daß registrierte Abweichungen nicht gelöscht werden, sondern bis zum Ende des Beobachtungszeitraumes erhalten bleiben. Es wird also nur festgehalten, daß in einem bestimmten Kanal eine Änderung erfolgt ist. Die Anzahl der Änderungen wird bei der beispielhaften Schaltung nicht erfasst. Für eine erste, übersichtliche Erfassung der Änderungen und der damit verbundenen Fehler ist aber eine Erfassung der Anzahl der Änderungen nur hinderlich, da sie die Übersichtlichkeit vermindert.

Es ist aber auch denkbar, durch eine Abänderung der Schaltung die Zahl der Änderungen zu erfassen und dadurch Fehlerraten festzustellen.

Nach Ablauf des Beobachtungszeitraumes kann die Speichereinrichtung beispielsweise mittels Mikroprozessor ausgelesen werden. Dies kann dadurch geschehen, daß der Mikroprozessor entweder über die Steuerlogik 4 in die Schaltungsanordnung eingreift. Möglich ist aber auch eine Ausgestaltung der Speichereinrichtung 3 als Dual-Port-Speicher, bei dem ohne Beeinflussung der Schaltungsanordnung auf den Inhalt der Speichereinrichtung 3 zugegriffen werden kann.

Denkbar ist aber auch eine Ausgestaltung der Erfindung in der Weise, daß die hier dargestellte Schaltungsanordnung doppelt vorgesehen ist und die Überwachung in aufeinander folgenden Beobachtungszeiträumen mittels einer der beiden Schaltungsanordnungen abwechselnd erfolgt. Dadurch kann die jeweils inaktive Schaltungsanordnung mit geeigneten Mitteln ausgelesen werden, ohne daß die Überwachung des digitalen, periodischen Signales unterbrochen wird.

## Patentansprüche

1. Verfahren zur Überwachung eines digitalen, periodischen Eingangssignals mit Signalspeicherung während eines Beobachtungszeitraumes,
**dadurch gekennzeichnet,** daß
- lediglich das Bitmuster einer im Beobachtungszeitraum ersten Signalperiode des digitalen Eingangssignals für den Beobachtungszeitraum gespeichert wird,
- die Bitmuster im Beoachtungszeitraum folgender Signalperioden des digitalen Eingangssignals jeweils mit dem gespeicherten Bitmuster der ersten Signalperiode verglichen werden und
- die Ergebnisse der Vergleiche in einem Abweichungsspeicher registriert werden.

2. Verfahren nach Anspruch 1,
**dadurch gekennzeichnet,** daß
nach Ablauf eines Beobachtungszeitraumes das Bitmuster der ersten Signalperiode angezeigt wird, und daß diejenigen Bits, bei denen Abweichungen registriert wurden, markiert werden.

3. Verfahren nach Anspruch 1 oder Anspruch 2,
**dadurch gekennzeichnet,** daß
der Vergleich des Bitmusters der ersten Signalperiode eines Beobachtungszeitraumes mit dem Bitmuster einer folgenden Signalperiode durch eine byteweise Exklusiv-Oder-Verknüpfung der Bitmuster geschieht.

4. Schaltungsanordnung zur Überwachung eines digitalen, periodischen Eingangssignals mit Signalspeicherung während eines Beobachtungszeitraumes,
**dadurch gekennzeichnet,** daß
- an eine mit dem periodischen Eingangssignal beaufschlagte erste Schaltung (1) zur Seriell/Parallel-Umsetzung des digitalen, periodischen Signales ein erster Eingang einer Vergleichslogik (2) angeschlossen ist,
- die Vergleichslogik (2) über einen bidirektionalen Datenbus (D) mit einer Speichereinrichtung (3) verbunden ist und
- eine Steuereinrichtung (4) vorgesehen ist, welche über Kontrolleitungen (A, C) mit der Vergleichslogik (2) und der Speichereinrichtung (3) verbunden ist und dafür sorgt, daß
- lediglich das Bitmuster einer im Beobachtungszeitraum ersten Signalperiode des digitalen Eingangssignals für den Beobachtungszeitraum gespeichert wird,
- die Bitmuster im Beoachtungszeitraum folgender Signalperioden des digitalen Eingangssignals jeweils mit dem gespeicherten Bitmuster der ersten Signalperiode verglichen werden und
- die Ergebnisse der Vergleiche in einem Abweichungsspeicherbereich der Speichereinrichtung (3) registriert werden.

## Claims

1. A method for monitoring a digital periodical input signal in which the signal is stored during an observed time period, wherein
- merely the bit pattern of a signal period of the digital input signal which comes first in the observed time period is stored for the observed time period,
- the bit patterns of signal periods of the digital input signal which are subsequent in said observed time period are each compared with the stored bit pattern of said first signal period, and
- the results of the comparisons are registered in a deviation store.

2. The method as claimed in claim 1, wherein after the observed time period has elapsed, the bit pattern of the first signal period is displayed, and those bits in which deviations have been detected are marked.

3. The method as claimed in claims 1 or 2, wherein the comparison of the bit pattern of the first signal period of an observed time period with the bit pattern of a subsequent signal period is effected by a byte-by-byte XOR operation of the bit patterns.

4. A circuit for monitoring a digital periodical input signal in which the signal is stored during an observed time period, wherein
- a first input of a comparison logic (2) is connected to a first circuit (1) for a serial/parallel conversion of the digital periodical signal, the first circuit receiving the periodical input signal,
- the comparison logic (2) is connected to storage means (3) via a bidirectional databus (D), and
- a control means (4) is provided which is connected to said comparison logic (2) and said storage means (3) via control lines (A, C) and ensures that
- merely the bit pattern of the signal period of the digital input signal which comes first in the observed time period is stored for the observed time period,
- the bit patterns of signal periods of the digital input signal which are subsequent in said observed time period are each compared with the stored bit pattern of said first signal period, and
- the results of the comparisons are registered in a deviation storage area of said storage means (3).

## Revendications

1. Méthode de surveillance d'un signal d'entrée numérique périodique avec mémorisation de signaux pendant un intervalle de temps d'observation,
**caractérisée en ce que,**
- seul le profil binaire d'une première période du signal numérique d'entrée lors de l'intervalle de temps d'observation n'est mémorisée pour l'intervalle de temps d'observation,
- les profils binaires de l'intervalle de temps d'observation des périodes suivantes du signal numérique d'entrée sont comparées chacun avec le profil binaire mémorisé de la première période de signal et
- les résultats des comparaisons sont enregistrés dans une mémoire d'écarts.

2. Méthode suivant la revendication 1,
**caractérisée en ce que** le profil binaire de la première période de signal est indiqué après écoulement d'un intervalle de temps d'observation, et que les bits pour lesquels un écart a été enregistré sont marqués.

3. Méthode suivant l'une des revendications 1 ou 2,
**caractérisée en ce que** la comparaison du profil binaire de la première période de signal d'un intervalle de temps d'observation avec le profil binaire d'une période de signal suivante est effectuée par une liaison OU exclusif byte-par-byte.

4. Dispositif de surveillance d'un signal d'entrée numérique périodique avec mémorisation de signaux pendant un intervalle de temps d'observation,
**caractérisée en ce que**
- une première entrée d'un circuit de logique de comparaison (2) pour la conversion série/parallèle du signal numérique périodique est connectée à un premier circuit (1) alimenté par le signal d'entrée périodique,
- le circuit de logique de comparaison (2) est lié à un dispositif de mémoire (3) par le biais d'un bus de données bidirectionnel (D) et
- un dispositif de commande (4) est prévu, lié au circuit de logique de comparaison (2) et au dispositif de mémoire (3) par des lignes de commande (A, C) et destiné à ce que
- seul le profil binaire d'une première période du signal numérique d'entrée lors de l'intervalle de temps d'observation n'est mémorisée pour l'intervalle de temps d'observation,
- les profils binaires de l'intervalle de temps d'observation des périodes suivantes du signal numérique d'entrée sont comparées chacun avec le profil binaire mémorisé de la première période de signal et
- les résultats des comparaisons sont enregistrés dans une mémoire d'écartement du dispositif de mémoire (3).
